# EUROPEAN PATENT APPLICATION

(11) **EP 4 794 465 A1**
(43) Date of publication of application: **19.08.2026**
(21) Application number: 25207279.8
(22) Date of filing: 07.10.2025
(51) Int. Cl.: H10B 12/00

(54) **MEMORY CELL ARRAY AND MEMORY DEVICE INCLUDING THEREOF**

(30) Priority: 17.02.2025 KR 20250019959
(71) Applicant: Samsung Electronics Co., Ltd., Suwon-si, Gyeonggi-do 16677 (KR)
(72) Inventor: KIM, Yongjun, Suwon-si (KR); WOO, Seunghan, Suwon-si (KR); YOON, Hyun-Chul, Suwon-si (KR)
(74) Representative: Marks & Clerk LLP

(57) **Abstract**

A memory cell array may include a first memory cell including a first transistor structure and a first capacitor structure, a second memory cell including a second transistor structure and a second capacitor structure, and a first wordline contact connected to the first transistor structure and the second transistor structure, wherein the first capacitor structure is spaced apart from the first transistor structure in a first direction, and the second capacitor structure is spaced apart from the second transistor structure in a second direction different from the first direction.

## Description

### BACKGROUND

Dynamic random access memory (DRAM) devices are widely used as the main memory of processors. A DRAM device may store data in form of electrical charges stored in a capacitor included in each of a plurality of memory cells.

### SUMMARY

According to the recent technical trend toward higher capacity and higher integration of DRAM devices, various technologies are being studied to implement a larger number of memory cells in a small-area memory cell array. However, as a greater number of memory cells are implemented in a small area memory cell array, the spacing between the capacitors of memory cells may become excessively narrow. In this case, the reliability of data stored in the DRAM device may be deteriorated due to mutual influence between capacitors.

Some aspects of the present disclosure help to resolve the foregoing technical challenge. For example, some aspects of the present disclosure provide memory cell arrays in which capacitors of each of the plurality of memory cells are arranged with wider spacings, and memory devices including the same.

A memory cell array according to some implementations of the present disclosure may include a first memory cell including a first transistor structure and a first capacitor structure, a second memory cell including a second transistor structure and a second capacitor structure, and a first wordline contact connected to the first transistor structure and the second transistor structure, wherein the first capacitor structure is spaced apart from the first transistor structure in a first direction, and the second capacitor structure is spaced apart from the second transistor structure in a second direction different from the first direction.

A memory cell array including one or more dynamic random access memory (DRAM) cells according to some implementations of the present disclosure may include: a substrate; a channel layer formed on the substrate and including a first transistor structure; and a capacitor layer including a first capacitor structure which is electrically connected to the first transistor structure, wherein a first point on the substrate corresponding to the first transistor structure is different from a second point on the substrate corresponding to the first capacitor structure.

A memory device according to some implementations of the present disclosure may include: a memory cell array; a plurality of wordlines connected to the memory cell array; and a plurality of bitlines connected to the memory cell array, wherein: the plurality of wordlines include a first wordline, the memory cell array includes a first plurality of memory cells connected to the first wordline, the first plurality of memory cells includes a first plurality of capacitor structures, respectively, a capacitor interval for the first plurality of capacitor structures is greater than a bitline interval for the plurality of bitlines.

A memory cell array according to some implementations of the present disclosure may include: a plurality of wordline contacts extended along a first direction; and a plurality of memory cells respectively including a plurality of capacitor structures arranged in a matrix form along the first direction and a second direction perpendicular to the first direction, wherein: the plurality of capacitor structures include first and second capacitor structures arranged along the first direction and adjacent to each other, the plurality of memory cells include a first memory cell including the first capacitor structure and a second memory cell including the second capacitor structure, and the first memory cell and the second memory cell are connected to different wordline contacts among the plurality of wordline contacts.

At least some of the above and other features of the invention are set out in the claims.

### BRIEF DESCRIPTION OF THE DRAWINGS

FIG. 1 is a block diagram showing an example of a memory device.
FIG. 2 is a block diagram showing an example of a configuration of the memory cell array of FIG. 1.
FIG. 3 is a block diagram showing a portion of the memory cell array of FIG. 2.
FIG. 4 is a layout diagram of an example of the memory cell array of FIG. 1.
FIG. 5 is a drawing illustrating an example of an arrangement of capacitors according to FIG. 4.
FIG. 6 is a layout diagram of an example of the memory cell array of FIG. 1.
FIG. 7 is a drawing illustrating an example of an arrangement of capacitors according to FIG. 6.
FIGS. 8 to 10 are diagrams showing an example of the structure of the memory cell array of FIG. 6 in more detail.
FIG. 11 is a layout diagram of an example of the memory cell array of FIG. 1.
FIG. 12 is a drawing illustrating an example of an arrangement of capacitors according to FIG. 11.
FIGS. 13 to 16 are diagrams showing an example of the structure of the memory cell array of FIG. 11 in more detail
FIG. 17 is a layout diagram of an example of the memory cell array of FIG. 1.
FIG. 18 is a layout diagram of an example of the memory cell array of FIG. 1.
FIG. 19 is a block diagram showing an example of a configuration of a memory system.

### DETAILED DESCRIPTION

It will be apparent to those skilled in the art that various changes and modifications of the examples described herein may be made without departing from the scope of the present disclosure. Moreover, descriptions of well-known functions and structures may be omitted for clarity and brevity.

Components that are described in the detailed description with reference to the terms "driver", "block", and the like will be implemented with software, hardware, or a combination thereof. For example, the software may be a machine code, firmware, an embedded code, and application software. For example, the hardware may include an electrical circuit, an electronic circuit, a processor, a computer, integrated circuit cores, a pressure sensor, a microelectromechanical system (MEMS), a passive element, or a combination thereof.

As used herein, the singular forms "a", "an", and "the" are intended to include the plural forms as well, unless the context clearly indicates otherwise. Additionally, the description may be specific to a portion of the device and the described structure may be repeated in other portions of the device. For example, the described structure may be an individual element of an array of elements forming the device. Accordingly, where the structure of a single element of a plurality of elements has been described, this structure may equally apply to other elements of the plurality of elements.

It is to be understood that when an element or layer is referred to as being "over", "above", "on", "below", "under", "beneath", "connected to" or "coupled to" another element or layer, it can be directly over, above, on, below, under, beneath, connected or coupled to the other element or layer or intervening elements or layers may be present. In contrast, when an element is referred to as being "directly over", "directly above", "directly on", "directly below", "directly under", "directly beneath", "directly connected to" or "directly coupled to" another element or layer, there are no intervening elements or layers present.

The terms "above", "below", "upper", "middle", "lower" may refer to relative positions along a particular direction (e.g. a vertical direction, such as the third direction D3 described below). Various directions may be defined relative to the structure of the devices described herein. Accordingly, the directions need not imply any particular orientation of the device in use.

Numerical terms such as "first", "second", "third" may be used to describe various elements or directions but the elements or directions are not limited by the terms. For instance, a "first element" may be referred to as a "second element" or a "first direction" may be referred to as a "second direction". The terms "first", "second", "third", etc. may be used to distinguish components or directions from each other and do not limit the present disclosure. For example, the terms "first", "second", "third", etc. may not necessarily involve an order or a numerical meaning of any form.

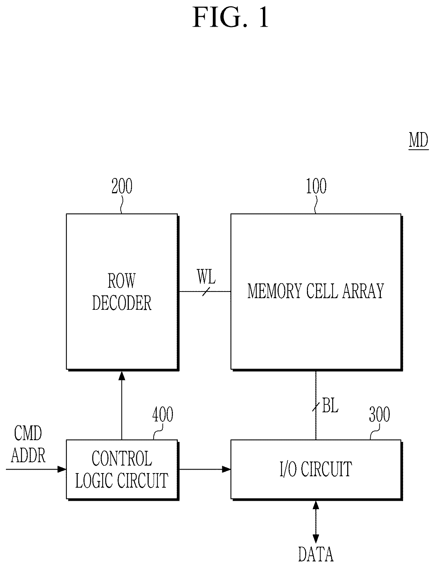

FIG. 1 is a block diagram showing an example of a memory device. Referring to FIG. 1, a memory device MD may include a memory cell array 100, a row decoder 200, an input/output circuit 300, and a control logic circuit 400.

The memory cell array 100 may include a plurality of memory cells. The plurality of memory cells may be connected to a plurality of wordlines WL and a plurality of bitlines BL. For simplicity of explanation, it is assumed below that each of the plurality of memory cells is implemented as a dynamic random access memory (DRAM) cell. For example, each of the plurality of memory cells may include a capacitor structure.

The row decoder 200 may control the plurality of wordlines WL. For example, the row decoder 200 may activate some of the plurality of wordlines WL based on address ADDR provided to the control logic circuit 400.

The input/output circuit 300 may be connected to the plurality of bitlines BL. The input/output circuit 300 may output data DATA stored in the memory cell array 100 to outside (e.g., an external system, such as a host device) based on the voltage levels of the plurality of bitlines BL. The input/output circuit 300 may write data DATA provided from the outside into the memory cell array 100 by controlling the voltage levels of the plurality of bitlines BL.

The control logic circuit 400 may receive command CMD and address ADDR. The control logic circuit 400 may control overall operations of the memory device MD based on the command CMD and address ADDR. For example, the control logic circuit 400 may control the operation of the row decoder 200 and the input/output circuit 300 based on the command CMD and the address ADDR.

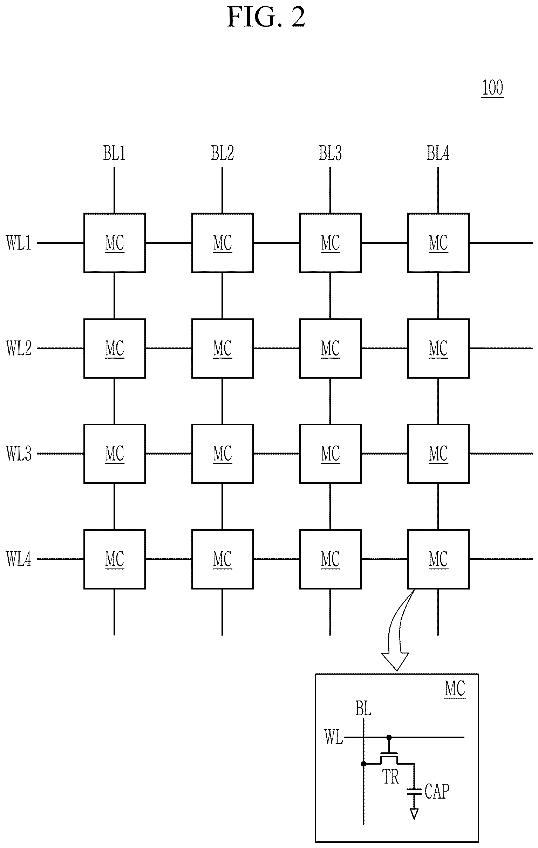

FIG. 2 is a block diagram showing a configuration of the memory cell array of FIG. 1 in more detail. Referring to FIGS. 1 and 2, the memory cell array 100 may include a plurality of memory cells MC. The plurality of memory cells MC may be arranged in a matrix form.

The plurality of memory cells MC may be connected to the plurality of wordlines WL. The plurality of memory cells MC may be connected to the plurality of bitlines BL. For a more concise explanation, memory cells MC connected to the first to fourth wordlines WL1 to WL4 and the first to fourth bitlines BL1 to BL4 are representatively illustrated in FIG. 2, but the number of elements may be varied. For example, the scope of the present disclosure is not limited to the number of wordlines WL, the number of bitlines BL, and the number of memory cells MC shown in FIG. 2.

Each of the plurality of memory cells MC may be a DRAM cell. For example, each of the plurality of memory cells MC may include a transistor TR and a capacitor CAP, and may store data based on amount of charge stored in the capacitor CAP.

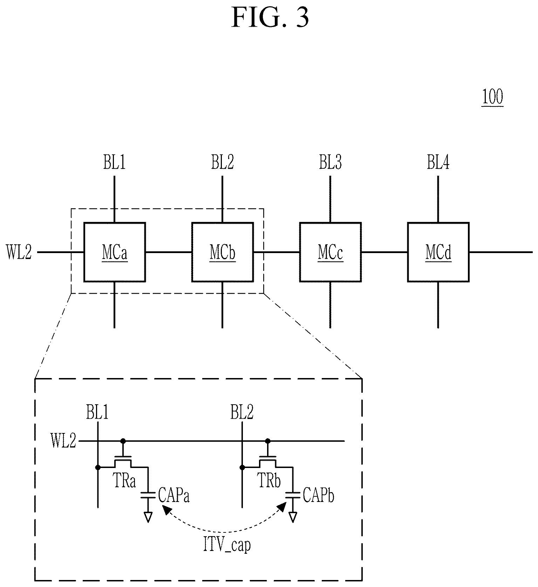

FIG. 3 is a block diagram showing a portion of the memory cell array of FIG. 2 in more detail. Referring to FIGS. 1 to 3, the second wordline WL2 may be connected to the first to fourth memory cells MCa to MCd. The first to fourth memory cells MCa to MCd may be connected to the first to fourth bitlines BL1 to BL4, respectively. For a more concise explanation, the relationship between memory cells MC connected to the second wordline WL2 will be described as a representative example below. However, it will be understood that the disclosed configuration can apply for other wordlines and bitlines.

The input/output circuit 300 may simultaneously perform a read operation for at least some of the memory cells MC connected to a single wordline WL. For example, the input/output circuit 300 may perform read operations for the first to fourth memory cells MCa to MCd simultaneously.

Error correction for data read from a memory cell array 100 may be performed based on a unit of data read simultaneously from memory cells MC. For example, when read operations for the first to fourth memory cells MCa to MCd are performed simultaneously, an error correction code (ECC) may be applied to a set of bits read from the first to fourth memory cells MCa to MCd.

A number of correctable bits based on the error correction code may be determined in advance depending on the type of the error correction code. For example, the correction ability of the error correction code may be '1-bit'. In this case, if the bits read simultaneously from the memory cells MC include more than '1-bit' error bits, the error correction based on the error correction code may fail, and thus the reliability of the memory device MD may deteriorate. In other words, for error correction based on an error correction code to be successful, it may be required that errors do not occur simultaneously in two or more of the memory cells MC being read simultaneously (e.g., the plurality of memory cells MC connected to a single wordline WL).

In some cases, the number of bits that an error correction code may correct may be a trade-off with the storage efficiency of a memory device MD. Accordingly, it may be difficult to apply error correction codes with relatively high correction capabilities, such as '2-bit'.

In some implementations, the error correction code may be executed in a host device (not shown) controlling the memory device MD. However, the scope of the present disclosure is not limited thereto, and the error correction code may also be executed in the memory device MD, e.g., in the input/output circuit 300. For example, the memory device MD may be implemented to support on-die error correction code (on-die ECC). That is, the scope of the present disclosure is not limited in the specific location and manner in which error correction code is executed.

The physical gap (e.g., spacing or interval) between capacitors CAP included in adjacent memory cells MC connected to one wordline WL may be referred to as a capacitor interval ITV_cap. For example, a first memory cell MCa may include a first transistor TRa and a first capacitor CAPa. The second memory cell MCb may include a second transistor TRb and a second capacitor CAPb. In this case, the physical gap between the first capacitor CAPa and the second capacitor CAPb may be referred to as a capacitor interval ITV_cap.

In some implementations, the capacitor interval ITV_cap may vary depending on various factors such as process deviation for the capacitors CAP. For example, the capacitor interval ITV_cap between the first capacitor CAPa and the second capacitor CAPb may be larger or smaller than the intended size (e.g., the design value or planed value for the capacitor interval ITV_cap).

If the capacitor interval ITV_cap is not large enough, adjacent capacitors CAP may electrically influence each other. For example, due to various factors such as process deviation, the capacitor interval ITV_cap between the first capacitor CAPa and the second capacitor CAPb may become excessively smaller (e.g., smaller than a certain threshold value) than intended. In this case, the amount of charge in the second capacitor CAPb may change (e.g., be affected) depending on the amount of charge in the first capacitor CAPa, and the amount of charge in the first capacitor CAPa may change (e.g., be affected) depending on the amount of charge in the second capacitor CAPb. In this case, data stored in the first capacitor CAPa and data stored in the second capacitor CAPb may be damaged (e.g., corrupted).

For example, if the capacitor interval ITV_cap is not designed to be sufficiently large, the capacitor interval ITV_cap between some capacitors CAP may become excessively small due to various reasons such as process deviation. In this case, there is a very high possibility that errors occur simultaneously in two or more of the memory cells MC being read simultaneously, and thus, there is a very high possibility that uncorrectable errors occur in the data stored in the memory device MD.

When the capacitor interval ITV_cap is excessively small (e.g., less than a certain threshold value), adjacent capacitors CAP may affect each other in various ways. For example, when adjacent capacitors CAP are in directly contact with each other, the charge stored in the capacitors CAP may move directly through the conductive path formed between the capacitors CAP. As another example, even if adjacent capacitors CAPs are not in direct contact, electrical coupling may occur between adjacent capacitors CAPs, and thus the amount of charge stored in the capacitors CAPs may vary. That is, the scope of the present disclosure is not limited to a specific reason why the adjacent capacitors CAPs influence each other.

However, based on the description provided herein, the physical spacing between capacitors CAP included in memory cells MC connected to one wordline WL may be sufficiently large (e.g., wide). That is, according to some implementations of the present disclosure, the capacitor interval ITV_cap may be sufficiently large. In this case, even if the capacitor interval ITV_cap becomes smaller than intended due to process errors or other reasons, the probability that the capacitor interval ITV_cap becomes small enough for adjacent capacitors CAPs to electrically influence each other may be very small. In this case, the possibility that errors occur simultaneously in two or more memory cells MC that are read simultaneously may be greatly reduced, and thus the possibility that uncorrectable errors occur in data stored in a memory device MD may be greatly reduced. Therefore, according to some implementations of the present disclosure, the reliability of data stored in the memory device MD may be improved.

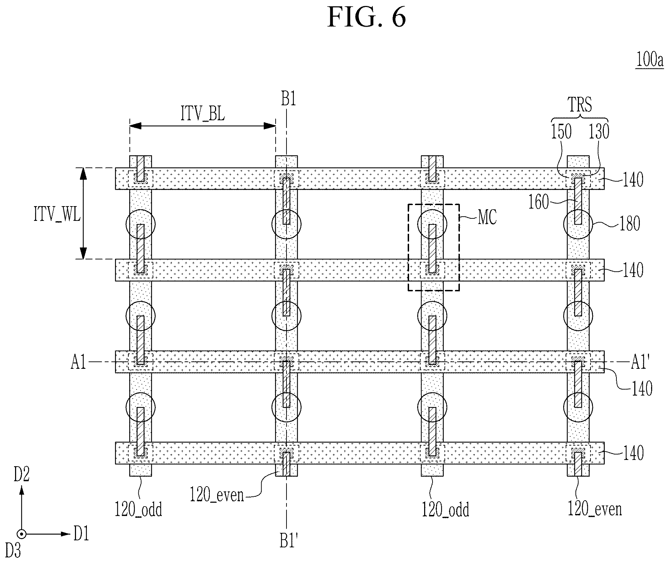

An example of a specific scheme of how the physical spacing (e.g., capacitor interval ITV_cap) between capacitors CAP included in memory cells MC connected to one wordline WL can be made sufficiently large is described in more detail with reference to FIGS. 6 to 18 below.

In some implementations, the correction capability of the error correction code may be 2-bit or more. Even in this case, the probability that an error of a number of bits exceeding the correction capability of an error correction code (i.e., an uncorrectable error) occurs in memory cells MC connected to one wordline WL may be reduced. That is, the scope of the present disclosure is not limited to a specific correction capability of an error correction code applied to data stored in a memory device MD.

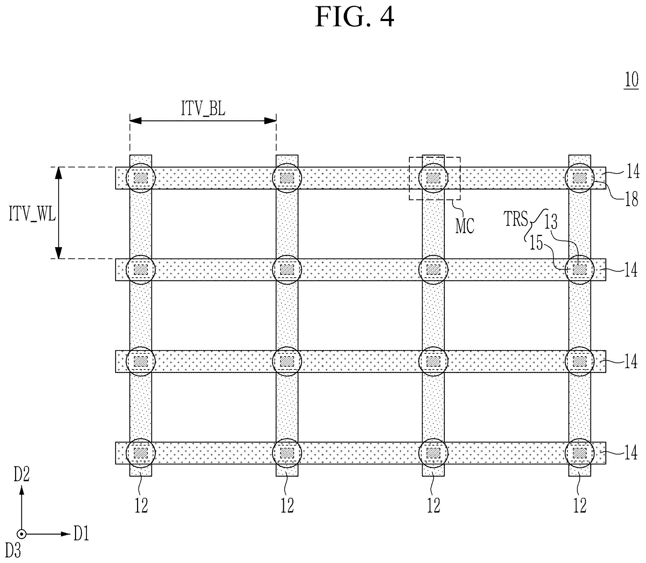

FIG. 4 is a layout diagram of an example of the memory cell array of FIG. 1 according to a comparative example. Referring to FIGS. 1 to 4, the memory cell array 100 of FIG. 1 may be implemented as the memory cell array 10 of FIG. 4.

The memory cell array 10 may include a plurality of bitline contacts 12. The plurality of bitline contacts 12 may be spaced apart from each other in a first direction D1 and extend in a second direction D2. The second direction D2 may cross (e.g., may be perpendicular to) the first direction D1. The plurality of bitline contacts 12 may respectively correspond to the plurality of bitlines BL described above with reference to FIG. 2. The spacing or periodicity between the plurality of bitline contacts 12 may be referred to as a bitline interval ITV_BL. A bitline contact may be otherwise known as a bitline.

The plurality of bitline contacts 12 may include doped polysilicon, a metal, a conductive metal nitride, a conductive metal silicide, a conductive metal oxide, or a combination thereof. For example, the plurality of bitline contacts 12 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof. However, the scope of the present disclosure is not limited thereto. For example, the plurality of bitline contacts 12 may include a two-dimensional semiconductor material such as graphene, carbon nanotubes, etc.

A plurality of transistor structures TRS may be formed on the plurality of bitline contacts 12. For example, the plurality of transistor structures TRS may be arranged in a matrix form on a plurality of bitline contacts 12 with spaced apart in the first direction D1 and the second direction D2. Each of the plurality of transistor structures TRS may include a channel structure 13 and a gate insulating layer 15. Each of the plurality of transistor structures TRS may correspond to a transistor TR of a different memory cell MC described above with reference to FIG. 2.

Each of the plurality of channel structures 13 may have a width along the first direction D1 and a height along a third direction D3. The third direction D3 may cross (e.g., may be perpendicular to) the first direction D1 and the second direction D2. In some implementations, the height of the channel structure 13 may be greater than the width of the channel structure 13. For example, the height of the channel structure 13 may be 2 to 10 times the width of the channel structure 13, but the scope of the present disclosure is not limited thereto.

In some implementations, the channel structure 13 may include various types of oxide semiconductors such as InxGayZnzO, InxGaySizO, InxSnyZnzO, InxZnyO, ZnxO, ZnxSnyO, ZnxOyN, ZrxZnySnzO, SnxO, HfxInyZnzO, GaxZnySnzO, AlxZnySnzO, YbxGayZnzO, InxGayO, etc, or combinations thereof. However, the scope of the present disclosure is not limited thereto. For example, the channel structure 13 may include a two-dimensional semiconductor material such as graphene, carbon nanotube, etc.

In some implementations, the channel structure 13 may have a band gap energy greater than the band gap energy of silicon. For example, the channel structure 13 may have a band gap energy of 1.5 eV to 5.6 eV. As another example, the channel structure 13 may have a band gap energy of 2.0 eV to 4.0 eV. However, the scope of the present disclosure is not limited thereto.

The gate insulating layer 15 may surround the outer surface of the channel structure 13 (e.g., surfaces perpendicular to the third direction D3).

In some implementations, the gate insulating layer 15 may be formed of a silicon oxide layer, a silicon oxynitride layer, a high-k dielectric layer having a higher dielectric constant than silicon oxide, or a combination thereof. The high-k dielectric layer may be made of a metal oxide or a metal oxide-nitride. For example, a high-k dielectric layer which is usable as the gate insulating layer 15 may be formed of HfO2, HfSiO, HfSiON, HfTaO, HfTiO, HfZrO, ZrO2, Al2O3, or a combination thereof, but the scope of the present disclosure is not limited thereto.

In some implementations, the transistor structure TRS may be referred to as a vertical channel transistor. However, the scope of the present disclosure is not limited to this transistor type.

The memory cell array 10 may include a plurality of wordline contacts 14. The plurality of wordline contacts 14 may be spaced apart from each other in the second direction D2 and extend in the first direction D1. The plurality of wordline contacts 14 may make contact to the outer surface of a transistor structure TRS (e.g., a gate insulating layer 15).

The plurality of wordline contacts 14 may respectively correspond to the plurality of wordlines WL described above with reference to FIG. 2. The spacing or periodicity between the plurality of wordline contacts 14 may be referred to as a wordline interval ITV_WL. A wordline contact may be otherwise known as a wordline.

In some implementations, the wordline contact 14 may include doped polysilicon, a metal, a conductive metal nitride, a conductive metal silicide, a conductive metal oxide, or a combination thereof. For example, the wordline contact 14 may be implemented with doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof. However, the scope of the present disclosure is not limited thereto.

A capacitor structure 18 may be placed on each of the transistor structures TRS. For example, the capacitor structures 18 may be arranged to vertically overlap each of the channel structures 13. Accordingly, a plurality of capacitor structures 18 may be arranged in a matrix form spaced apart in the first direction D1 and the second direction D2. Each of the plurality of capacitor structures 18 may correspond to a capacitor CAP of a different memory cell MC described above with reference to FIG. 2.

In some implementations, a lower part of the channel structure 13 (e.g., a part adjacent to the bitline contact 12) may function as a first source/drain region, and an upper part of the channel structure 13 (e.g., a part adjacent to the capacitor structure 18) may function as a second source/drain region. A part between the first and second source/drain regions of the channel structure 13 may function as a channel of a transistor structure TRS.

That is, according to the example of FIG. 4, a memory cell MC including the transistor structure TRS and the capacitor structure 18 may be positioned at each location where the plurality of bitline contacts 12 and the plurality of wordline contacts 14 intersect.

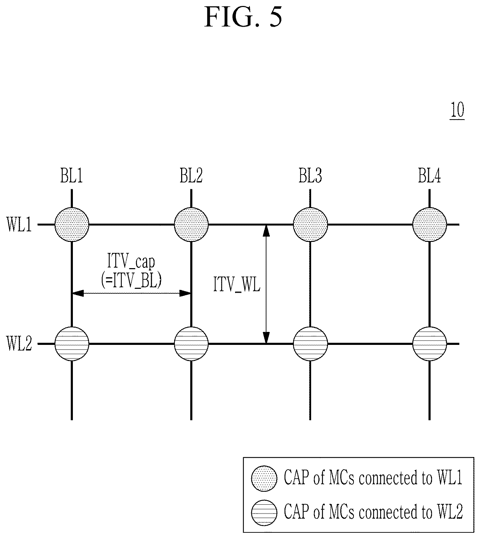

FIG. 5 is a drawing that more simply shows the arrangement of capacitors according to the example of FIG. 4. Referring to FIGS. 1 to 5, capacitors CAPs of memory cells MC connected to the first wordline WL1 may be designed to be arranged with bitline intervals ITV_BL on the first wordline WL1. Similarly, the capacitors CAP of the memory cells MC connected to the second wordline WL2 may be designed to be arranged with bitline intervals ITV_BL on the second wordline WL2.

That is, according to the example of FIG. 4, the spacing between capacitors CAP of a plurality of memory cells MC connected to one wordline WL may be designed to have a size corresponding (e.g., equal) to the bitline interval ITV_BL. In other words, according to the example of FIG. 4, the capacitor interval ITV_cap may be designed to have a size corresponding (e.g., equal) to the bitline interval ITV_BL.

According to some implementations of the present disclosure, the capacitor interval ITV_cap may be designed to have a value greater than the bitline interval ITV_BL. In this case, even if the capacitor interval ITV_cap becomes smaller than intended due to various reasons such as process errors, the possibility that the capacitors of the memory cells MC connected to one wordline WL affect each other may be reduced. The specific way in which the capacitor interval ITV_cap is designed to have a value greater than the bitline interval ITV_BL is described in more detail with reference to FIGS. 6 to 18 below.

FIG. 6 is a layout diagram of an example of the memory cell array of FIG. 1. Referring to FIGS. 1 to 3 and FIG. 6, the memory cell array 100 of FIG. 1 may be implemented as a memory cell array 100a of FIG. 6.

The memory cell array 100a may include a plurality of bitline contacts 120, a plurality of wordline contacts 140, a plurality of transistor structures TRS, a plurality of spacing contacts 160, and a plurality of capacitor structures 180. Each of the plurality of transistor structures TRS may include a channel structure 130 and a gate insulating layer 150. Since the configuration and function of the bitline contacts 120, wordline contacts 140, channel structures 130, and gate insulating layers 150 are similar to the configuration and function of the bitline contacts 12, wordline contacts 14, channel structures 13, and gate insulating layers 15 described above with reference to FIG. 4, a detailed description thereof is omitted.

Each of the plurality of transistor structures TRS may be connected to a spacing contact 160. For example, a spacing contact 160 may be connected to an upper surface of each of the plurality of transistor structures TRS (e.g., the surface opposite the surface where the transistor structure TRS contacts the bitline contact 120).

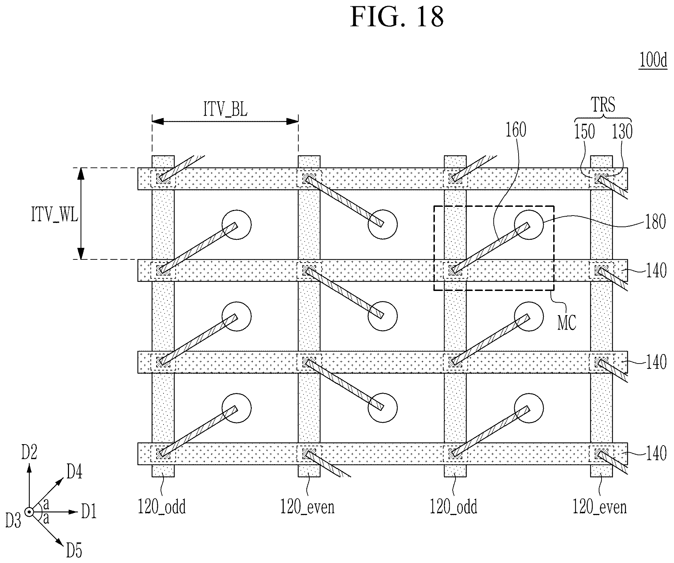

The spacing contacts 160 connected to each of the plurality of transistor structures TRS may extend in one of the second direction D2 or a direction opposite to the second direction D2. That is, hereinafter, an example in which each spacing contact 160 extends in a direction parallel to the direction in which the bitline contact 120 extends is representatively described. However, the scope of the present disclosure is not limited thereto, and the spacing contact 160 connected to each of the plurality of transistor structures TRS may extend in one of any direction perpendicular to the third direction D3 and a direction symmetrical thereto with respect to the first direction D1. For example, the spacing contact 160 connected to each of the plurality of transistor structures TRS may extend in a direction that is not parallel to the bitline contact 120. For example, the spacing contact 160 connected to each of the plurality of transistor structures TRS may extend in a direction that is perpendicular to the third direction D3 and that is not parallel (e.g., that crosses or intersects) the first direction D1, and a direction symmetrical thereto with respect to the first direction D1. Another example in which the spacing contact 160 extends in a direction not parallel to the bitline contact 120 will be described in more detail with reference to FIG. 18 below.

Each of the plurality of bitline contacts 120 may be classified into an odd bitline contact 120_odd and an even bitline contact 120_even according to their arranged order.

Spacing contacts 160 connected to transistor structures TRS connected to odd bitline contacts 120_odd may extend along the second direction D2. Spacing contacts 160 connected to transistor structures TRS connected to even bitline contacts 120_even may extend along a direction opposite to the second direction D2. Alternatively, spacing contacts 160 connected to transistor structures TRS connected to odd bitline contacts 120_odd may extend along a direction opposite to the second direction D2 and Spacing contacts 160 connected to transistor structures TRS connected to even bitline contacts 120_even may extend along the second direction D2.

That is, according to some implementations (as shown in FIG. 6), the spacing contacts 160 connected to some of the plurality of transistor structures TRS connected to one wordline contact 140 may extend along the second direction D2, and the spacing contacts 160 connected to the others of the plurality of transistor structures TRS connected to the one wordline contact 140 may extend along a direction opposite to the second direction D2. For example, two adjacent transistor structures TRS among a plurality of transistor structures TRS connected to one wordline contact 140 may be respectively connected to spacing contacts 160 extending in different (e.g., opposite) directions.

In some implementations, the lengths of the spacing contacts 160 connected to each of the plurality of transistor structures TRS may be the same. For example, the length along the second direction D2 of the spacing contact 160 connected to each of the transistor structures TRS connected to the odd bitline contact 120_odd may be the same as the length along the opposite direction of the second direction D2 of the spacing contact 160 connected to each of the transistor structures TRS connected to the even bitline contact 120_even. However, the scope of the present disclosure is not limited to this length configuration.

A capacitor structure 180 may be connected to the spacing contact 160. For example, each spacing contact 160 may include a first contact point connected to a transistor structure TRS and a second contact point connected to a capacitor structure 180. The second contact point may be spaced apart from the first contact point along the direction in which the spacing contact 160 extends. In some implementations, the first contact point and the second contact point may be located on different surfaces of the spacing contact 160. Each of the plurality of capacitor structures 180 may correspond to a capacitor CAP of a different memory cell MC described above with reference to FIG. 2.

Accordingly, in some implementations (as shown in FIG. 6), the capacitor structure 180 corresponding to the transistor structure TRS connected to the odd bitline contact 120_odd may be spaced apart from corresponding transistor structure TRS along the second direction D2; and the capacitor structure 180 corresponding to the transistor structure TRS connected to the even bitline contact 120_even may be spaced apart from corresponding transistor structure TRS along the opposite direction of the second direction D2. Generally, the spacing contacts 160 for two adjacent capacitor structures 180 connected to one wordline contact 140 may offset the two adjacent capacitor structures 180 from each other in the second direction D2.

A transistor structure TRS, a spacing contact 160, and a capacitor structure 180 may form one memory cell MC. For example, a channel structure 130 included in a transistor structure TRS may be electrically connected to the capacitor structure 180 through the spacing contact 160. In some implementations, the spacing contact 160 may include various types of conductive materials, such as a metal, a conductive metal nitride, a conductive metal silicide, a conductive metal oxide, and the like. However, the scope of the present disclosure is not limited to this specific composition of the spacing contact 160.

Accordingly, in some implementations, the capacitor structure 180 may not be formed on corresponding transistor structure TRS. For example, the capacitor structure 180 may be spaced apart from the transistor structure TRS by the spacing contact 160.

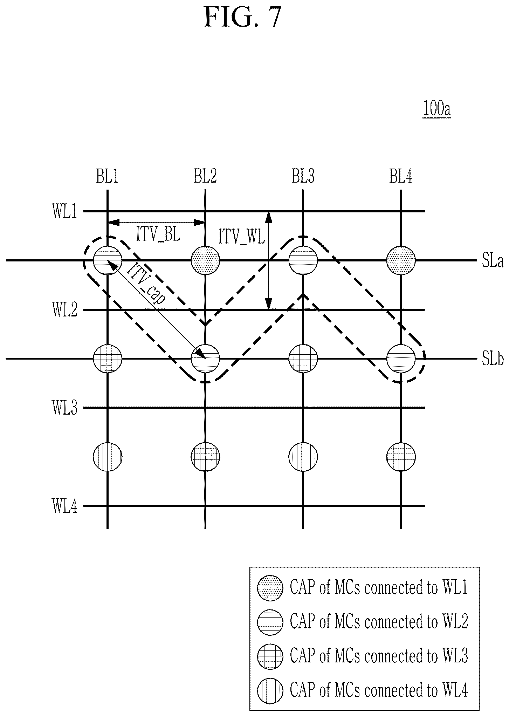

FIG. 7 is a drawing that more simply shows an arrangement of the capacitors according to FIG. 6. Referring to FIGS. 1 to 3 and FIGS. 6 to 7, capacitors CAPs of memory cells MC connected to different wordlines WL may be illustrated in different patterns. In the following, for a more concise explanation, the arrangement of capacitors CAP illustrated with horizontal stripes (i.e., capacitors CAP of memory cells MC connected to the second wordline WL2) will be described as a representative example. However, the scope of the present disclosure is not limited thereto, and capacitors of memory cells connected to other wordlines may also be arranged in a similar manner.

The capacitors CAP of the memory cells MC connected to the second wordline WL2 may be arranged in a zigzag form. For example, capacitors CAP included in memory cells MC connected to odd bitlines (more specifically, odd bitline contacts 120_odd) among memory cells MC connected to the second wordline WL2 may be arranged on a first straight line SLa. Capacitors CAP included in memory cells MC connected to even bitlines (more specifically, even bitline contacts 120_even) among memory cells MC connected to the second wordline WL2 may be arranged on a second straight line SLb. The first straight line SLa and the second straight line SLb may be parallel to each other. The first straight line SLa and the second straight line SLb may be spaced apart from each other in the second direction D2.

In this way, the capacitor interval ITV_cap may be designed to have a larger value than the bitline interval ITV_BL. In this case, even if the capacitor interval ITV_cap becomes smaller than intended due to various reasons such as process errors, the possibility that the capacitors of the memory cells MC connected to one wordline WL affect each other may be reduced. Furthermore, the bitline interval ITV_BL may be decreased while maintaining a sufficiently large capacitor interval ITV_CAP.

In some implementations, the interval between the first straight line SLa and the second straight line SLb described above may be a wordline interval ITV_WL. For example, the spacing between the transistor structure TRS and corresponding capacitor structure 180 included in memory cells MC connected to the odd bitlines, and the spacing between the transistor structure TRS and corresponding capacitor structure 180 included in memory cells MC connected to the even bitlines, may both be half of the wordline interval ITV_WL. However, the scope of the present disclosure is not limited thereto, and the gap between the transistor structure TRS and corresponding capacitor structure 180 included in the memory cells MC connected to the odd bitlines, and the gap between the transistor structure TRS and corresponding capacitor structure 180 included in the memory cells MC connected to the even bitlines may be different from each other. For example, the length of the spacing contact 160 connected to the transistor structure TRS connected to the odd bitline contact 120_odd may be different from the length of the spacing contact 160 connected to the transistor structure TRS connected to the even bitline contact 120_even. However, hereinafter, it will be assumed that the lengths of the plurality of spacing contacts 160 included in the memory cell array 100a are the same as each other, and the spacing between the plurality of transistor structures TRS and the plurality of capacitor structures 180 respectively corresponding thereto included in the memory cell array 100a are the same as each other.

In some implementations, when the interval between the first straight line SLa and the second straight line SLb is a wordline interval ITV_WL, the size of the capacitor interval ITV_cap for the memory cells MC connected to the second wordline WL2 may be designed as the square root of the sum of the square of the wordline interval ITV_WL and the square of the bitline interval ITV_BL.

In some implementations, when the interval between the first straight line SLa and the second straight line SLb is a wordline interval ITV_WL, and the memory cells MC connected to the other wordlines WL are also arranged in a similar manner, the plurality of capacitor structures 180 included in the memory cell array 100a may be arranged in a matrix structure along the first direction D1 and the second direction D2. For example, capacitors CAP included in some of the memory cells MC connected to the first wordline WL1 may be arranged on the first straight line SLa; and capacitors CAP included in some of the memory cells MC connected to the third wordline WL3 may be arranged on the second straight line SLb.

As a result, when comparing the structure of the memory cell array 100a to the memory cell array 10a described with reference to FIGS. 4 and 5, the memory cell array 100a may be implemented with substantially the same area as the memory cell array 10a, and the capacitor interval ITV_cap for the memory cells MC connected to one wordline WL may be maximized. Therefore, the probability that errors occur simultaneously in bits stored in memory cells MC connected to one wordline WL (e.g., the probability that an uncorrectable error occurs) may be reduced, so that the reliability of the memory device MD may be improved.

Additionally, according to some implementations of the present disclosure, a capacitor CAP closest to a capacitor CAP included in a memory cell MC connected to a specific wordline may be a capacitor CAP included in a memory cell MC connected to another wordline WL. Therefore, even if a bit stored in one capacitor CAP is damaged (e.g., corrupted) and it causes damage (e.g., corruption) to a bit stored in another capacitor CAP closest thereto, since the damaged (e.g., corrupted) bits exists in memory cells connected to different wordlines, the success probability of error correction based on the error correction code may be increased.

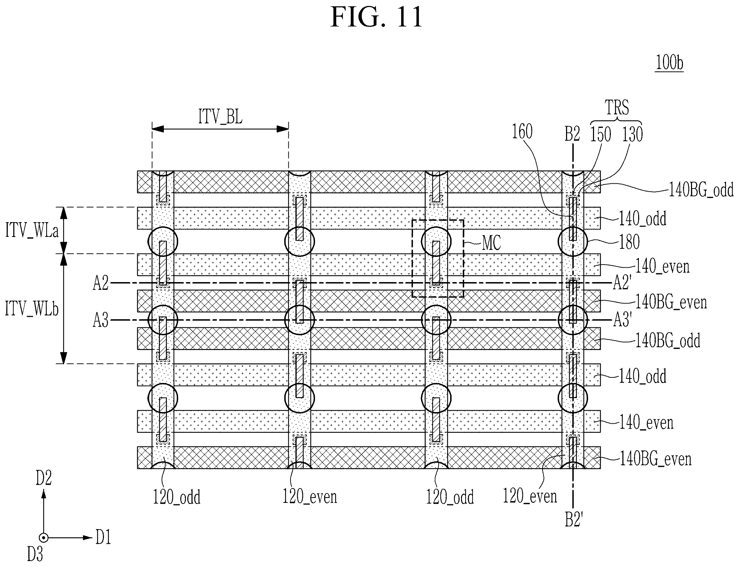

For a more concise explanation, an embodiment having single-gate transistor structure in which the transistor structure TRS is surrounded by a wordline contact 140 is described in FIG. 7, but the scope of the present disclosure is not limited thereto. For example, the wordline contact 140 may be implemented to contact only one side of the transistor structure TRS. Furthermore, the transistor structure TRS may be implemented as dual-gate transistor structure which contacts not only the wordline contact 140 but also the back-gate contact (not shown). An embodiment in which the transistor structure TRS has the dual-gate transistor structure is described in more detail with reference to FIGS. 11 to 17 below.

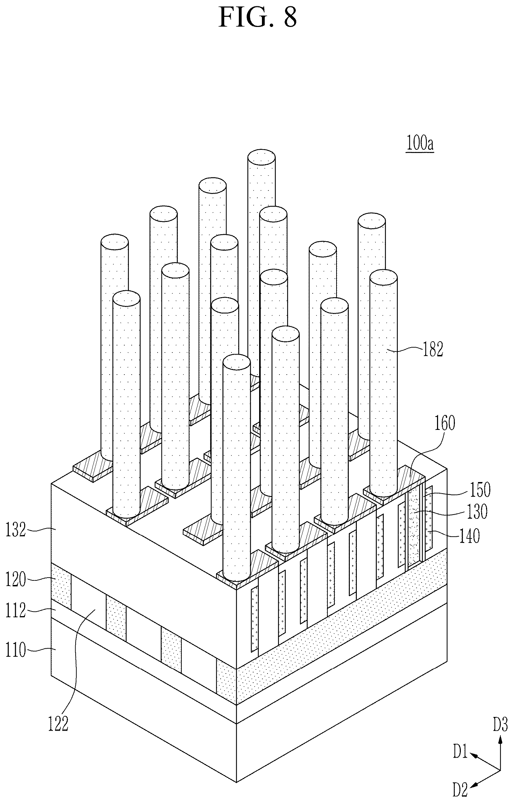

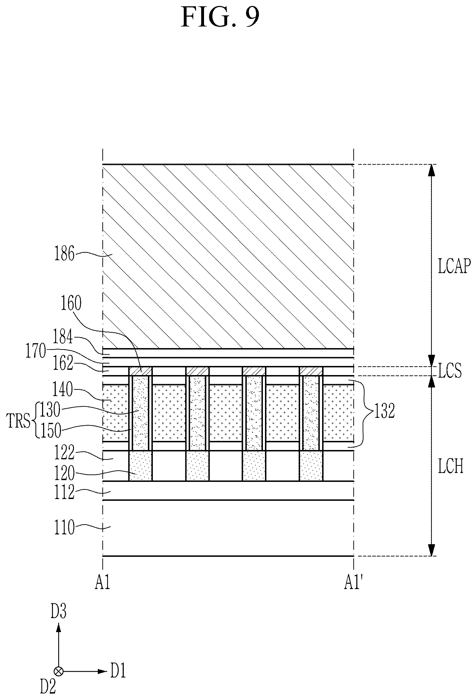

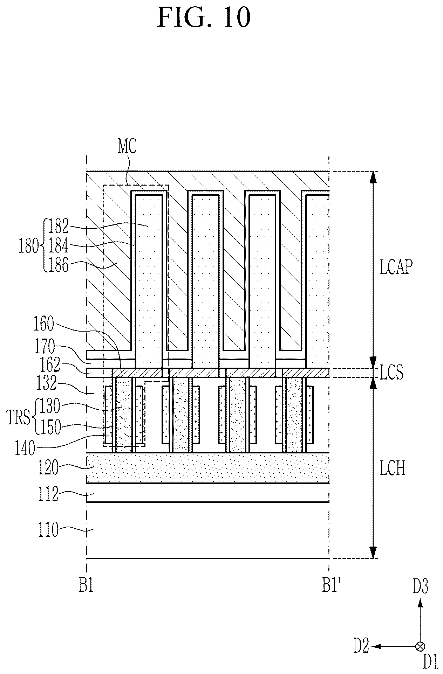

FIGS. 8 to 10 are drawings showing an example of the structure of the memory cell array of FIG. 6 in more detail. For example, FIG. 8 is a perspective view showing the structure of the memory cell array of FIG. 6 in more detail, FIG. 9 is a cross-sectional view taken along line A1-A1' of FIG. 6, and FIG. 10 is a cross-sectional view taken along line B1-B1' of FIG. 6.

For a more concise explanation, an example having a single-gate transistor structure in which the transistor structure TRS is surrounded by a wordline contact 140 is described in FIG. 8, but the scope of the present disclosure is not limited thereto. For example, the wordline contact 140 may be implemented to contact only one side of the transistor structure TRS. Furthermore, the transistor structure TRS may be implemented as dual-gate transistor structure that contacts not only the wordline contact 140 but also the back-gate contact (not shown). An example in which the transistor structure TRS has the dual-gate transistor structure is described in more detail with reference to FIGS. 11 to 17 below.

Referring to FIGS. 1 to 3 and FIGS. 6 to 10, a memory cell array 100a may include a substrate 110, a channel layer LCH, a capacitor spacing layer LCS, and a capacitor layer LCAP.

The channel layer LCH may be located on the substrate 110. The channel layer LCH may include a lower insulating layer 112, bitline contacts 120, first insulating patterns 122, channel structures 130, insulating structures 132, wordline contacts 140, and gate insulating layers 150. The channel layer LCH may be located on a first surface (e.g., an upper surface) of the substrate 110. The third direction D3 may be perpendicular to the first surface of the substrate 110. The first direction D1 and the second direction D2 may be parallel to the first surface of the substrate 110.

The capacitor spacing layer LCS may be located on the channel layer LCH. The capacitor spacing layer LCS may include a plurality of spacing contacts 160 and a second insulating pattern 162.

The capacitor layer LCAP may be located on the capacitor spacing layer LCS. The capacitor layer LCAP may include an etch stop layer 170 and a plurality of capacitor structures 180.

The lower insulating layer 112 may be located on the substrate 110. On the lower insulating layer 112, a plurality of bitline contacts 120 may be arranged spaced apart from each other in the first direction D1 and extended in the second direction D2. First insulating patterns 122 may be arranged on the lower insulating layer 112 to fill the spaces between the plurality of bitline contacts 120. The first insulating patterns 122 may extend in the second direction D2, and the upper surfaces of the first insulating patterns 122 may have the same level (e.g., in the third direction D3) as the upper surfaces of the plurality of bitline contacts 120. Each of the plurality of bitline contacts 120 may function as a bitline BL.

The plurality of channel structures 130 may be arranged in a matrix form spaced apart along a first direction D1 and a second direction D2 on the plurality of bitline contacts 120. Each of the plurality of channel structures 130 may have a first width along the first direction D1 and a first height along the third direction D3. A side surface of each of the plurality of channel structures 130 (e.g., a side surface perpendicular to the third direction D3) may be surrounded by the gate insulating layer 150.

The plurality of wordline contacts 140 may be spaced apart from each other in the second direction D2 and extend in the first direction D1. The plurality of wordline contacts 140 may contact a side surface of a transistor structure TRS (e.g., a gate insulating layer 150).

An insulating structure 132 may be formed on the first insulating patterns 122 and the plurality of bitline contacts 120. The insulating structure 132 may fill the remaining spaces within the channel layer LCH that are not filled by the transistor structures TRS and wordline contacts 140. For example, the insulating structure 132 may be implemented to fill spaces between wordline contacts 140, spaces between the plurality of wordline contacts 140 and the capacitor spacing layer LCS, and spaces between the plurality of wordline contacts 140 and the plurality of bitline contacts 120. The upper surface of the insulating structure 132 may have a same level (e.g., in the third direction D3) as the upper surfaces of the plurality of transistor structures TRS (e.g., the level of the upper surface of the channel layer LCH).

The scope of the present disclosure is not limited to the configuration of the insulating structure 132 shown in FIGS. 8 to 10. For example, the insulating structure 132 may be implemented as a combination of two or more insulating structures (e.g., insulating patterns) including an insulating material.

A plurality of spacing contacts 160 may be formed on the channel layer LCH. The plurality of spacing contacts 160 may be connected to the upper surfaces of different transistor structures TRS. Each of the plurality of spacing contacts 160 may extend in the second direction D2 or in a direction opposite to the second direction D2 from a contact point with the transistor structure TRS. The second insulating pattern 162 may fill the remaining spaces within the capacitor spacing layer LCS that are not filled by the plurality of spacing contacts 160.

The etch stop layer 170 may be located on the capacitor spacing layer LCS. The etch stop layer 170 may be implemented as an insulator. The plurality of capacitor structures 180 may be arranged on the etch stop layer 170. However, in order to explain a clear connection among the main technical components of the present disclosure, the illustration of the etch stop layer 170 is omitted in FIG. 8.

Each capacitor structure 180 may include a lower electrode 182, a capacitor dielectric layer 184, and an upper electrode 186. In some implementations, a plurality of capacitor structures 180 may share an upper electrode 186 configured to receive a plate voltage from an external source. However, the scope of the present disclosure is not limited thereto.

The lower electrode 182 may penetrate the etch stop layer 170 and be electrically connected to one surface (e.g., upper surface) of the spacing contact 160. The lower electrode 182 may be formed in a pillar type extending in the third direction D3, but the scope of the present disclosure is not limited thereto.

As such, in some implementations, a first point (e.g., a first position in D1, D2 coordinates) on the substrate 110 corresponding to a transistor structure TRS may be different from a second point (e.g., a second position in D1, D2 coordinates) on the substrate 110 corresponding to a capacitor structure 180 electrically connected to the transistor structure TRS. For example, a transistor structure TRS may extend in the third direction D3 from a point which is spaced apart by a first distance in a third direction D3 from a first location on a substrate 110, and a capacitor structure 180 electrically connected to the transistor structure TRS may extend in the third direction D3 from a point which is spaced apart by a second distance in the third direction D3 from a second location on the substrate 110. The first position where a first line contacts the substrate 110 may be different from the second position where a second line contacts the substrate 110, wherein the first line is extended in the opposite direction of the third direction D3 from the point where the transistor structure TRS contacts the bitline contact 120, and wherein the second line is extended in the opposite direction of the third direction D3 from the point where the capacitor structure 180 electrically connected to the transistor structure TRS contacts the spacing contact 160. Within one memory cell MC, the capacitor structure 180 and the transistor structure TRS may be offset from one another in one or both of the first direction D1 and the second direction D2.

FIG. 11 is a layout diagram of another example of the memory cell array of FIG. 1. Referring to FIGS. 1 to 3 and FIG. 11, the memory cell array 100 of FIG. 1 may be implemented as the memory cell array 100b of FIG. 11.

The memory cell array 100b may include a plurality of bitline contacts 120, a plurality of wordline contacts 140, a plurality of back gate contacts 140BG, and a plurality of transistor structures TRS. Each of the plurality of transistor structures TRS may include a channel structure 130 and a gate insulating layer 150. That is, unlike the description provided for the memory cell array 100a described above with reference to FIG. 6, the memory cell array 100b may further include the plurality of back gate contacts 140BG. The plurality of back gate contacts 140BG may correspond to back gate terminals of a plurality of transistor structures TRS. For example, the plurality of back gate contacts 140BG may determine the bulk potential of the plurality of transistor structures TRS. In some implementations, each of the plurality of back gate contacts 140BG and the plurality of wordline contacts 140 may be referred to as a gate contact.

Since the configuration and function of the bitline contact 120, the channel structure 130, the plurality of wordline contacts 140, and the gate insulating layer 150 have been described above with reference to FIG. 6, a detailed description thereof is omitted. Below, the differences between the memory cell array 100b and the memory cell array 100a will be mainly explained.

The plurality of wordline contacts 140 may extend in the first direction D1 and may make contact to a first side surface of the transistor structures TRS. The plurality of back gate contacts 140BG may extend in the first direction D1 and may make contact to a second surface located opposite the first side surface of the transistor structures TRS. The first side surface may be opposite the second side surface in the second direction D2. In some implementations, each of the plurality of transistor structures TRS may make contact to one wordline contact 140 and one back gate contact 140BG.

Each of the plurality of wordline contacts 140 may be classified into an odd wordline contact 140_odd and an even wordline contact 140_even according to the arranged order. Each of the plurality of back gate contacts 140BG may be classified into an odd back gate contact 140BG_odd and an even back gate contact 140BG_even according to the arranged order.

The odd wordline contacts 140_odd may contact the transistor structures TRS in the second direction D2, and the even-numbered wordline contacts 140_even may contact the transistor structures TRS in an opposite direction of the second direction D2. The odd back gate contacts 140BG_odd may contact the transistor structures TRS in the opposite direction D2 of the second direction, and the even back gate contacts 140BG_even may contact the transistor structures TRS in the second direction D2.

Accordingly, the plurality of wordline contacts 140 and the plurality of back gate contacts 140BG may be arranged alternately two by two, along the second direction D2. Therefore, the spacing between the plurality of wordline contacts 140 may not be uniform (e.g., may be variable). For example, the spacing between the plurality of wordline contacts 140 may be determined with one of the first wordline interval ITV_WLa and the second wordline interval ITV_WLb.

The first wordline interval ITV_WLa may refer to the spacing (e.g., pitch) between two adjacent wordline contacts 140 where a back gate contact 140BG is not placed between the wordline contacts 140. The second wordline interval ITV_WLb may refer to the spacing (e.g., pitch) between two adjacent wordline contacts 140 where a back gate contact 140BG is placed between the wordline contacts 140.

The spacing contacts 160 connected to each of the plurality of transistor structures TRS may extend in either the second direction D2 or a direction opposite to the second direction D2. A capacitor structure 180 may be connected to each of the spacing contacts 160. The specific scheme how the capacitor structure 180 is connected to each of the plurality of transistor structures TRS through the spacing contact 160 is similar to that described above with reference to FIG. 6, so a detailed description is omitted.

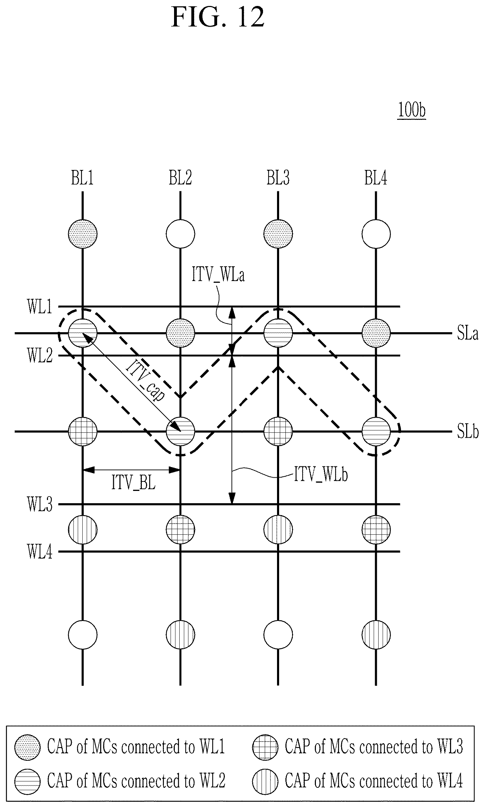

FIG. 12 is a drawing that more simply shows the arrangement of capacitors according to FIG. 11. Referring to FIGS. 1 to 3 and 11 to 12, capacitors CAPs of memory cells MC connected to different wordlines WL are illustrated in different patterns. For example, the arrangement of capacitors CAPs of memory cells MC connected to a second wordline WL2, which are illustrated with horizontal stripes, will be representatively described below. However, the scope of the present disclosure is not limited thereto, and capacitors of memory cells connected to other wordlines may also be arranged in a similar manner.

Similar to what was described above with reference to FIG. 7, the capacitors CAP of the memory cells MC connected to the second wordline WL2 may be arranged in a zigzag manner. For example, capacitors CAP included in memory cells MC connected to odd bitlines (more specifically, odd bitline contacts BL_odd) among memory cells MC connected to the second wordline WL2 may be arranged on a first straight line SLa. Capacitors CAP included in memory cells MC connected to even bitlines (more specifically, even bitline contacts BL_even) among memory cells MC connected to the second wordline WL2 may be arranged on a second straight line SLb. The first straight line SLa and the second straight line SLb may be spaced apart from each other in the second direction D2. In this way, the capacitor interval ITV_cap may be designed to be greater than the bitline interval ITV_BL.

The interval between the first straight line SLa and the second straight line SLb may be referred to as the average wordline interval ITV_WL_AVG. The average wordline interval ITV_WL_AVG may be an average of the first wordline interval ITV_WLa and the second wordline interval ITV_WLb.

In some implementations, the size of the capacitor interval ITV_cap for the memory cells MC connected to the second wordline WL2 may be designed as a square root of the sum of a square of the average wordline interval ITV_WL_AVG and a square of the bitline interval ITV_BL.

Capacitors CAP of memory cells MC connected to other wordlines WL may be arranged in a similar manner. In this case, a plurality of capacitor structures 180 included in the memory cell array 100b may be arranged in a matrix form along the first direction D1 and the second direction D2. For example, capacitors CAP included in some of the memory cells MC connected to the first wordline WL1 may be arranged on the first straight line SLa; and capacitors CAP included in some of the memory cells MC connected to the third wordline WL3 may be arranged on the second straight line SLb.

As a result, in some implementations, similarly to the memory cell array 100a described above with reference to FIGS. 6 and 7, the capacitor interval ITV_cap for the memory cells MC connected to one wordline WL may be increased. Accordingly, when the memory cell array 100 of FIG. 1 is implemented as a memory cell array 100b, the probability that errors occur simultaneously in bits stored in memory cells MC connected to one wordline WL (e.g., the probability that an uncorrectable error occur) may be reduced, so the reliability of the memory device MD may be improved.

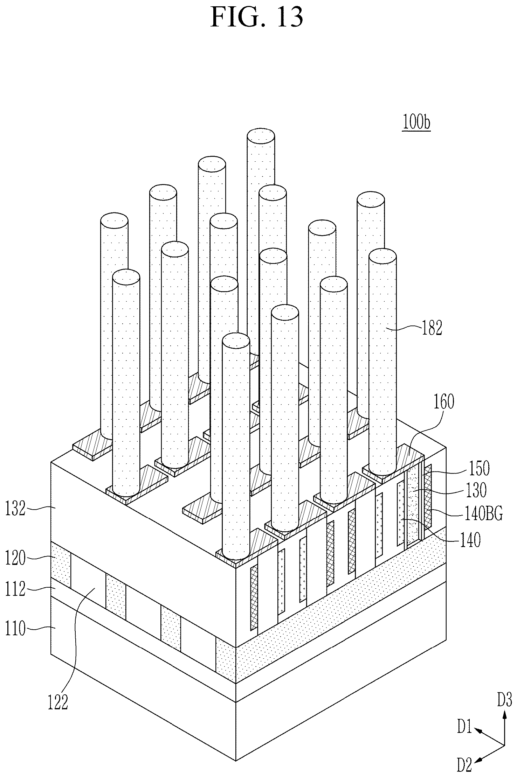

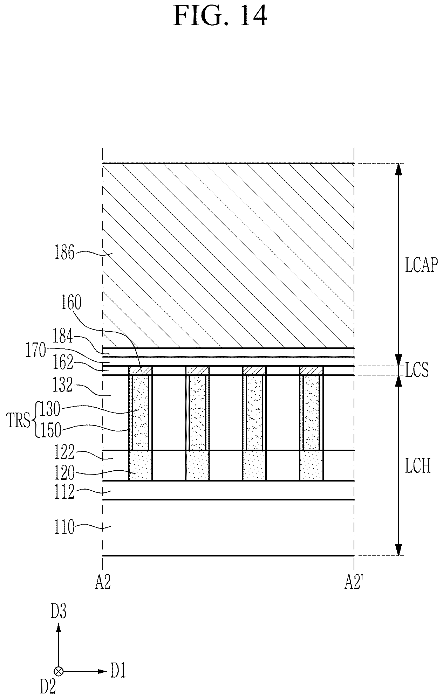

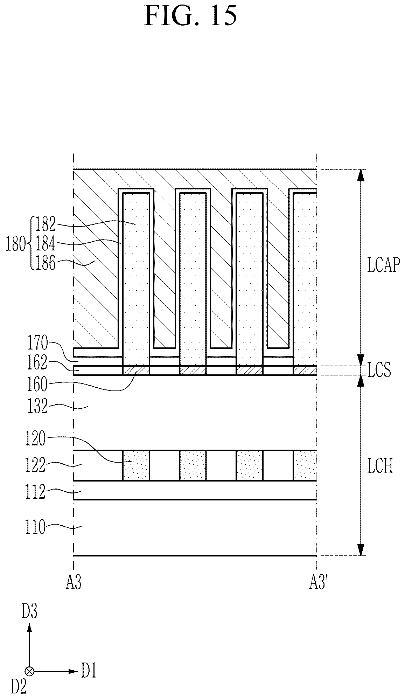

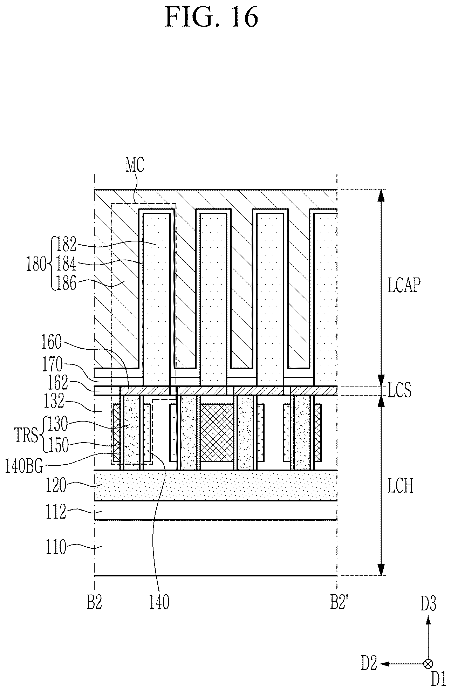

FIGS. 13 to 16 are drawings showing an example of the structure of the memory cell array of FIG. 11 in more detail. For example, FIG. 13 is a perspective view showing the structure of the memory cell array of FIG. 11 in more detail, FIG. 14 is a cross-sectional view taken along line A2-A2' of FIG. 11, FIG. 15 is a cross-sectional view taken along line A3-A3' of FIG. 11, and FIG. 16 is a cross-sectional view taken along line B2-B2' of FIG. 11.

Referring to FIGS. 1 to 3 and FIGS. 13 to 16, the memory cell array 100b may include a substrate 110, a channel layer LCH, a capacitor spacing layer LCS, and a capacitor layer LCAP.

The channel layer LCH may be located on the substrate 110. The channel layer LCH may include a lower insulating layer 112, bitline contacts 120, first insulating patterns 122, channel structures 130, insulating structures 132, wordline contacts 140, back gate contacts 140BG, and gate insulating layers 150. The capacitor spacing layer LCS may be located on the channel layer LCH. The capacitor spacing layer LCS may include a plurality of spacing contacts 160 and a second insulating pattern 162. The capacitor layer LCAP may be located on the capacitor spacing layer LCS. The capacitor layer LCAP may include an etch stop layer 170 and a plurality of capacitor structures 180. Below, differences from the structure of the memory cell array 100a described above with reference to FIGS. 8 to 10 will be mainly described; the description provided for FIGS. 8 to 10 can otherwise be applied to FIGS. 13 to 16.

A lower insulating layer 112 may be located on the substrate 110. The plurality of bitline contacts 120 and first insulating patterns 122 may be arranged on the lower insulating layer 112.

The plurality of channel structures 130 may be arranged in a matrix form spaced apart along the first direction D1 and the second direction D2 on the plurality of bitline contacts 120. A side surface of each of the plurality of channel structures 130 may be surrounded by a gate insulating layer 150. That is, the plurality of transistor structures TRS may be arranged in a similar manner as described above with reference to FIGS. 6 to 10.

The plurality of wordline contacts 140 and the plurality of back gate contacts 140BG may be spaced apart from each other in the second direction D2 and may extend in the first direction D1. Each of the plurality of wordline contacts 140 and the plurality of back gate contacts 140BG may contact opposing side surfaces (e.g., gate insulating layer 15) of the transistor structures TRS. The order how the plurality of wordline contacts 140 and the plurality of back gate contacts 140BG are arranged has been described above with reference to FIG. 11, so a detailed description thereof is omitted.

The plurality of spacing contacts 160 may be formed on the channel layer LCH. The plurality of capacitor structures 180 may be arranged on the capacitor spacing layer LCS.

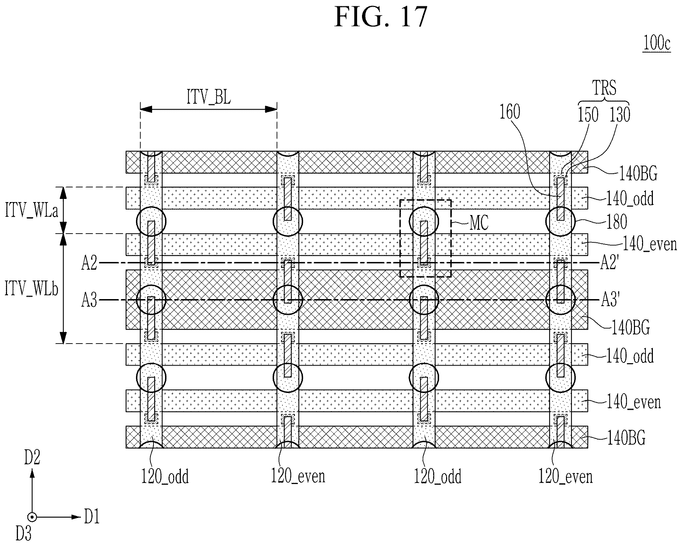

FIG. 17 is a layout diagram of an example of the memory cell array of FIG. 1. Referring to FIGS. 1 to 3, FIG. 11, and FIG. 17, the memory cell array 100 of FIG. 1 may be implemented as the memory cell array 100c of FIG. 17. The memory cell array 100c may be implemented similarly to the memory cell array 100b described above with reference to FIG. 11. Below, the differences between the memory cell array 100c and the memory cell array 100b will be mainly explained.

The memory cell array 100c may be implemented in a form in which the odd back gate contact 140BG_odd and even back gate contacts 140BG_even adjacent each other included in the memory cell array 100b are implemented as a single back gate contact 140BG. In this case, the plurality of wordline contacts 140 and the plurality of back gate contacts 140BG included in the memory cell array 100c may be arranged alternately with one back gate contact and two wordline contacts along the second direction D2.

The arrangement and spacing of each capacitor structure 180 included in the memory cell array 100c are similar to those described above with reference to FIGS. 11 to 16, and therefore, a detailed description thereof is omitted.

FIG. 18 is a layout diagram of an example of the memory cell array of FIG. 1. Referring to FIGS. 1 to 18, the memory cell array 100 of FIG. 1 may be implemented as the memory cell array 100d of FIG. 18. Below, the differences between the memory cell array 100d and the memory cell array 100a will be mainly explained.

The memory cell array 100d may include a plurality of bitline contacts 120, a plurality of wordline contacts 140, a plurality of transistor structures TRS, a plurality of spacing contacts 160, and a plurality of capacitor structures 180. Since the configuration and arrangement of the bitline contact 120, the wordline contact 140, and the plurality of transistor structures TRS are similar to those described above with reference to the memory cell array 100a, so a detailed description thereof is omitted.

A spacing contact 160 may be connected to the upper surface of each of the plurality of transistor structures TRS. The spacing contact 160 connected to each of the plurality of transistor structures TRS may extend in one of any specific direction perpendicular to the third direction D3 and a direction symmetrical to the specific direction with respect to the first direction D1 (e.g., a direction reflected across the first direction D1). The directions in which the spacing contacts 160 extend may intersect (e.g., may cross) the first direction D1.

For example, each spacing contact 160 may extend from a contact point with corresponding transistor structure TRS along one of a fourth direction D4 that is perpendicular to the third direction D3 and has an angle of "+a degrees" with respect to the first direction D1, and a fifth direction D5 that is perpendicular to the third direction D3 and has an angle of "-a degrees" with respect to the first direction D1. "a" may be a number greater than 0 and less than 180. The fourth direction D4 and the fifth direction D5 may be symmetrical with respect to the first direction D1. In some implementations, the example described above with reference to FIG. 6 may correspond to the case where angle "a" is 90 degrees.

A spacing contact 160 connected to each of a plurality of transistor structures TRS connected to an odd bitline contact 120_odd may extend along the fourth direction D4. A spacing contact 160 connected to each of a plurality of transistor structures TRS connected to an even bitline contact 120_even may extend along the fifth direction D5.

FIG. 18 illustrates an example in which the spacing contact 160 extends in a straight line, but the scope of the present disclosure is not limited to the specific shape of the spacing contact 160. For example, the spacing contact 160 may be implemented in a curved shape, a bent shape, a shape like the shape of the alphabet "L", etc. Accordingly, while the spacing contact 160 may extend between two points spaced along a straight line, the spacing contact 160 need not extend along that straight line, and can follow a bent and/or curved path to connect the two points.

A capacitor structure 180 may be connected to each of the spacing contacts 160. For example, the spacing contact 160 may include a first contact point connected to the transistor structure TRS and a second contact point connected to the capacitor structure 18. In this case, the second contact point may be spaced apart from the first contact point along the direction in which the spacing contact 160 extends. For example, the capacitor structure 18 may be spaced apart from corresponding transistor structure TRS along the fourth direction D4 or along the fifth direction D5. In this case, similarly to what was described above with reference to FIGS. 6 and 7, the size of the capacitor interval ITV_cap for the memory cells MC connected to one wordline WL may be designed as the square root of the sum of the square of the wordline interval ITV_WL and the square of the bitline interval ITV_BL.

For a more concise explanation, FIG. 18 representatively describes the configuration of a memory cell array 100d implemented in a similar manner to the memory cell array 100a of FIG. 6, but the scope of the present disclosure is not limited thereto. For example, the extension direction of the spacing contacts 160 and the arrangement scheme of the capacitor structure 180 described in the memory cell array 100d may be applied in a similar manner to the memory cell array 100b described above with reference to FIG. 11 or the memory cell array 100c described above with reference to FIG. 17.

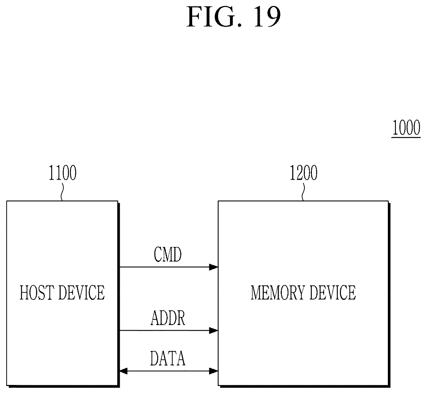

FIG. 19 is a block diagram showing an example of a configuration of a memory system. Referring to FIGS. 1 to 19, a memory system 1000 may include a host device 1100 and a memory device 1200.

The host device 1100 may control the memory device 1200 by issuing various types of commands CMD and addresses ADDR. For example, the host device 1100 may issue a read command to read data DATA from the memory device 1200, or issue a write command to store data DATA in the memory device 1200.

In some implementations, the host device 1100 may issue various types of commands CMD and addresses ADDR in the form of command/address signals C/A.

In some implementations, the host device 1100 may include one of various types of processors, such as a central processing unit CPU, a graphic processing unit GPU, and the like.

In some implementations, the host device 1100 may execute error correction code. For example, the host device 1100 may execute a single error correction code (SEC). In this case, the host device 1100 may correct an error in the read data only when an error of 1 bit or less occurs in the data read simultaneously from the memory device 1200.

The memory device 1200 may be implemented as a memory device MD described above with reference to FIGS. 1 to 18. For example, a memory device 1200 may include a memory cell array 100 in which capacitors CAPs of a plurality of memory cells MC connected to one wordline WL are arranged in a zigzag scheme. In this case, the probability that a 2-bit or more error occurs in data simultaneously read from the memory device 1200 by the host device 1100 may be minimized. In particular, if the host device 1100 is implemented to execute the SEC, the probability that an uncorrectable error occurs in data simultaneously read from the memory device 1200 to the host device 1100 may be reduced. Accordingly, the operational reliability of the memory system 1000 may be improved.

Particular embodiments are described herein with reference to "odd" and "even" word line contacts. It will be appreciated that the arrangement of odd and even word line contacts may be swapped relative to that shown herein, while still achieving the stated technical effect. More generally, "odd" word line contacts may be a first set of word line contacts and "even" word line contacts may be a second set of word line contacts, wherein the first and second sets of wordline contacts are alternated.

Embodiments are set out in the following Clauses:
Clause 1. A memory cell array comprising:
   a substrate;
   a channel layer on the substrate, wherein the channel layer includes a first transistor structure; and
   a capacitor layer including a first capacitor structure, wherein the first capacitor structure is electrically connected to the first transistor structure,
   wherein a first point on the substrate corresponding to the first transistor structure is different from a second point on the substrate corresponding to the first capacitor structure.
Clause 2. The memory cell array of Clause 1, wherein:
   on a third point spaced apart as a first distance from the first point along a first direction perpendicular to the substrate, the first transistor structure extends along the first direction,
   on a fourth point spaced apart as a second distance from the second point along the first direction, the first capacitor structure extends along the first direction.
Clause 3. The memory cell array of Clause 1 or Clause 2, further comprising:
   a capacitor spacing layer including a first spacing contact electrically connecting the first transistor structure and the first capacitor structure, wherein the capacitor spacing layer is located between the channel layer and the capacitor layer.
Clause 4. The memory cell array of Clause 3, wherein:
   the first spacing contact extends in a second direction, wherein the second direction is parallel to a direction from the first point to the second point.
Clause 5. The memory cell array of Clause 4, wherein:
   the channel layer further includes a second transistor structure,
   the capacitor layer further includes a second capacitor structure corresponding to the second transistor structure,
   the capacitor spacing layer further includes a second spacing contact electrically connecting the second transistor structure and the second capacitor structure,
   the first transistor structure and the second transistor structure are electrically connected to a first wordline contact, and
   the second spacing contact extends in a third direction different from the second direction.
Clause 6. The memory cell array of Clause 5, wherein:
   the first transistor structure is electrically connected to a first bitline contact,
   the second transistor structure is electrically connected to a second bitline contact adjacent to the first bitline contact among a plurality of bitline contacts.
Clause 7. A memory device, comprising:
   a memory cell array;
   a plurality of wordlines electrically connected to the memory cell array; and
   a plurality of bitlines electrically connected to the memory cell array, wherein:
      the plurality of wordlines include a first wordline,
      the memory cell array includes a first plurality of memory cells electrically connected to the first wordline,
      the first plurality of memory cells respectively include a first plurality of capacitor structures, and
      a capacitor interval for the first plurality of capacitor structures is greater than a bitline interval for the plurality of bitlines.
Clause 8. The memory device of Clause 7, wherein:
   the plurality of wordlines further includes a second wordline,
   the memory cell array further includes a second plurality of memory cells electrically connected to the second wordline,
   the second plurality of memory cells respectively include a second plurality of capacitor structures,
   each capacitor structure of the second plurality of capacitor structures is spaced at a same distance apart from a corresponding capacitor structure of the first plurality of capacitor structures along a first direction.
Clause 9. The memory device of Clause 7 or Clause 8, wherein:
   the plurality of bitlines includes a plurality of odd bitlines and a plurality of even bitlines,
   the first plurality of memory cells includes a third plurality of memory cells electrically connected to the plurality of odd bitlines and a fourth plurality of memory cells electrically connected to the plurality of even bitlines,
   capacitor structures included in the third plurality of memory cells are arranged on a first straight line, and
   capacitor structures included in the fourth plurality of memory cells are arranged on a second straight line that is parallel to the first straight line.
Clause 10. The memory device of any of Clauses 7-9, wherein:
   the capacitor interval is a square root of a sum of (i) a square of an average wordline interval for the plurality of wordlines and (i) a square of the bitline interval.
Clause 11. A memory cell array, comprising:
   a plurality of wordline contacts extended that extend along a first direction; and
   a plurality of memory cells respectively including a plurality of capacitor structures, wherein the plurality of memory cells are arranged in a matrix form pattern along the first direction and a second direction perpendicular to the first direction,
   wherein:
      the plurality of capacitor structures include first and second capacitor structures arranged spaced apart along the first direction and adjacent to each other among capacitor structures aligned with the first and second capacitor structures in the second direction,
      the plurality of memory cells include a first memory cell including the first capacitor structure and a second memory cell including the second capacitor structure, and
      the first memory cell and the second memory cell are electrically connected to different wordline contacts among the plurality of wordline contacts.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although examples have been described in detail above, the scope of the present disclosure is not limited thereto, and various modifications and improvements made by those skilled in the art also fall within the scope of the present disclosure.

## Claims

1. A memory cell array, comprising:
a first memory cell (MCa) including a first transistor structure (TRa) and a first capacitor structure (CAPa);
a second memory cell (MCb) including a second transistor structure (TRb) and a second capacitor structure (CAPb); and
a first wordline contact (140) electrically connected to the first transistor structure (TRa) and the second transistor structure (TRb),
wherein the first capacitor structure (CAPa) is spaced apart from the first transistor structure (TRa) in a first direction, and the second capacitor structure (CAPb) is spaced apart from the second transistor structure (TRb) in a second direction different from the first direction.

2. The memory cell array of claim 1, wherein:
the first wordline contact (140) extends in a third direction, and
the first direction is a reflection of the second direction across the third direction.

3. The memory cell array of claim 1 or claim 2, wherein:
the second direction is opposite to the first direction.

4. The memory cell array of any preceding claim, wherein:
a first gap between the first capacitor structure (CAPa) and the first transistor structure (TRa) is the same as a second gap between the second capacitor structure (CAPb) and the second transistor structure (TRb).

5. The memory cell array of any preceding claim, wherein:
the first memory cell (MCa) further includes a first spacing contact electrically connected between the first transistor structure (TRa) and the first capacitor structure (CAPa),
the second memory cell (MCb) further includes a second spacing contact electrically connected between the second transistor structure (TRb) and the second capacitor structure (CAPb),
the first spacing contact includes a first contact point at which the first spacing contact is electrically connected to a first channel structure included in the first transistor structure (TRa), and includes a second contact point at which the first spacing contact is electrically connected to a first lower electrode included in the first capacitor structure (CAPa),
the second spacing contact includes a third contact point at which the second spacing contact is electrically connected to a second channel structure included in the second transistor structure (TRb), and a fourth contact point at which the second spacing contact is electrically connected to a second lower electrode included in the second capacitor structure (CAPb),
the second contact point is spaced apart from the first contact point in the first direction, and
the fourth contact point is spaced apart from the third contact point in the second direction.

6. The memory cell array of any preceding claim, wherein:
the first transistor structure (TRa) is connected to a first bitline contact (120_odd), and
the second transistor structure (TRb) is connected to a second bitline contact (120_even) adjacent to the first bitline contact (120_odd) among a plurality of bitline contacts (120) arranged sequentially.

7. The memory cell array of claim 6, wherein:
a capacitor interval (ITV_cap) between the first capacitor structure (CAPa) and the second capacitor structure (CAPb) is greater than a bitline interval (ITV_BL) between the first bitline contact (120_odd) and the second bitline contact (120_even).

8. The memory cell array of any preceding claim, further comprising:
a third memory cell including a third transistor structure electrically connected to the first wordline contact (140), wherein the third memory cell includes a third capacitor structure; and
a fourth memory cell including a fourth transistor structure electrically connected to the first wordline contact (140), wherein the fourth memory cell includes a fourth capacitor structure,
wherein the first capacitor structure and the third capacitor structure are arranged on a first straight line, and the second capacitor structure and the fourth capacitor structure are arranged on a second straight line parallel to the first straight line.

9. The memory cell array of claim 8, further comprising:
a fifth memory cell including a fifth transistor structure and a fifth capacitor structure;
a sixth memory cell including a sixth transistor structure and a sixth capacitor structure;
a second wordline contact electrically connected to the fifth transistor structure; and
a third wordline contact electrically connected to the sixth transistor structure,
wherein the fifth transistor structure is arranged on the first straight line, and the sixth transistor structure is arranged on the second straight line.

10. The memory cell array of claim 9, wherein:
a first wordline interval (ITV_WLa) is an interval between the first wordline contact (140) and the second wordline contact,
a second wordline interval (ITV_WLb) is an interval between the first wordline contact and the third wordline contact,
an average of the first wordline interval (ITV_WLa) and the second wordline interval (ITV_WLb) is a first length,
a bitline interval (ITV_BL) between bitline contacts (120) of the memory cell array is a second length, and
a capacitor interval (ITV_cap) between the first capacitor structure (CAPa) and the second capacitor structure (CAPb) is a square root of a sum of (i) a square of the first length and (ii) a square of the second length.

11. A memory cell array comprising:
a substrate (110);
a channel layer (LCH) on the substrate (110), wherein the channel layer includes a first transistor structure (TRS); and
a capacitor layer (LCAP) including a first capacitor structure (180), wherein the first capacitor structure (180) is electrically connected to the first transistor structure (TRS),
wherein a first point on the substrate (110) corresponding to the first transistor structure (TRS) is different from a second point on the substrate (110) corresponding to the first capacitor structure (180).

12. The memory cell array of claim 11, wherein:
on a third point spaced apart from the first point by a first distance along a first direction perpendicular to the substrate (110), the first transistor structure (TRS) extends along the first direction,
on a fourth point spaced apart from the second point by a second distance along the first direction, the first capacitor structure (180) extends along the first direction.

13. The memory cell array of claim 11 or claim 12, further comprising:
a capacitor spacing layer (LCS) including a first spacing contact (160) electrically connecting the first transistor structure (TRS) and the first capacitor structure (180), wherein the capacitor spacing layer (LCS) is located between the channel layer (LCH) and the capacitor layer (LCAP).

14. The memory cell array of claim 13, wherein:
the first spacing contact (160) extends in a second direction, wherein the second direction is parallel to a direction from the first point to the second point.

15. The memory cell array of claim 14, wherein:
the channel layer (LCH) further includes a second transistor structure,
the capacitor layer (LCAP) further includes a second capacitor structure corresponding to the second transistor structure,
the capacitor spacing layer (LCS) further includes a second spacing contact electrically connecting the second transistor structure and the second capacitor structure,
the first transistor structure (TRS) and the second transistor structure are electrically connected to a first wordline contact (120), and
the second spacing contact extends in a third direction different from the second direction.
